# EUROPEAN PATENT APPLICATION

(11) **EP 1 248 211 A2**
(43) Date of publication of application: **09.10.2002**
(21) Application number: 02252384.9
(22) Date of filing: 02.04.2002
(51) Int. Cl.: G06F 17/50

(54) **Data processing system and design system**

(30) Priority: 06.04.2001 JP 2001107957; 19.11.2001 JP 2001353042
(71) Applicant: Pacific Design Inc., Tokyo 160-0023 (JP)
(72) Inventor: Shimogori, Shintaro, c/o Pacific Design Inc., Shinjuku-ku, Tokyo, 160-0023 (JP); Omura, Masayuki, c/o Pacific Design Inc., Shinjuku-ku, Tokyo, 160-0023 (JP); Takeda, Taigo, c/o Pacific Design Inc., Shinjuku-ku, Tokyo, 160-0023 (JP)
(74) Representative: Billington, Lawrence Emlyn

(57) **Abstract**

A data processing system that simulates operation of a processor for an application program including instruction sets is provided. To solve the problem that an instruction cycle of each of the instruction sets is performed with a plurality of pipeline stages in the processor, the data processing system comprises cycle-level simulating means for simulating operation of the processor controlled by the application program in cycles of the pipeline stages. By the cycle-level or based simulation of hardware using a high-speed simulator written in a high-level language such as C language, it becomes possible to provide a simulator that maintains the same level (cycle basis) of accuracy as a conventional RTL-based simulator but that operates with between several hundred and several thousand times the simulation speed.

## Description

The present invention relates to a system that simulates the operation of a processor.

During the 1990s, register-based description languages known as RTLs (register transfer languages) became widely used as the design language used when designing hardware. Verilog and VHDL (VHSIC Hardware Description Language) are typical examples of such languages. When these RTLs are used, signal transfers between registers and signal processing, which have registers as the base for hardware can be designed using logic expressions such as arithmetic operations (such as adding, subtracting, multiplying and dividing), logic operations (such as AND and OR), condition statements (such as "IF THEN ELSE"), and substitution statements. Accordingly, by using RTLs, it became possible to raise the prevailing level of abstraction for the design of logic circuits, thereby making it possible to raise the efficiency with which processors and the like could be designed.

After this, from the second half of the 1990s onwards, design languages called "operation level", which have with a higher level of abstraction, started to be used. These languages can be thought of as being extensions of register-based languages such as Verilog and VHDL, with Verilog and VHDL actually incorporating operation level description formats.

On the other hand, in operation level, there is no concept of "registers", with the description being focused on arithmetic operations, logic operations, condition statements, and substitution statements. "Operation level" belongs to the same category as standard software programming languages, so that from the latter half of the 1990s onwards, attempts have been made to design hardware using C language. C language is very common, offers many software resources, and unlike register-based languages (even when they are written so as to focus on operations) does not have a slow simulation speed. As one example, out of a specification written in C language and a specification written in RTL, the simulation speed of the specification written in C language is several thousands to several hundreds of thousands of times faster, so that there is an extremely large difference in speed. This difference in simulation speed is due to RTL being a language for designing hardware while C language is a language for designing software.

In recent years, a method has been developed for verifying the design of a processor. In this method, the software-development language C is used to produce the initial design for the specification of an application that is executed by the processor, with the application being finally converted into the hardware-development language RTL. Also, in another proposed method, when developing and designing a processor that is realized by a specification written in C, rather than converting the specification directly into hardware, the specification may be converted into hardware with part of the specification being realized by a special-purpose processor or special-purpose processors.

In USP 6,301,650, the applicant of the present invention discloses a data processing apparatus that can be equipped with customizable special-purpose instructions. In the method used to design this kind of processor, a description, which may be as an instruction set-based or assembler-based description, is used as an intermediate state between the C language description and the RTL. With a description based on instructions sets, the execution state of a processor can be more accurately simulated than for the case with a C language specification where the description is based on logic only. Accordingly, simulators for (instruction level) descriptions in instruction format have been developed in recent years, with such devices being referred to as instruction set simulators (ISS).

However, since a conventional ISS system simulates the execution of an instruction sequence, such as a sequence described by assembler instructions, it has not been possible to perform a simulation of the hardware itself. Accordingly, with regard to real time processing, such as reads and writes for I/O (input/output) signals and interrupt handling, while a correct simulation can be made as to whether these functions are executed or not, it has not always been possible to perform a simulation that is correct with regard to the hardware. On a view of clock cycle level, the simulation ends up being somewhat different from the actual operation of the processor. ISS systems are fundamentally simulators for simulating instruction sequences, so while this is not a problem for software design. However, when the simulation is being performed for hardware for a case where an application program is being run on a processor, ISS systems cannot provide a satisfactory simulation. Accordingly, when a conventional ISS system is used, a C language description can be used, making it possible to perform a high-speed simulation of the execution state on an instruction set basis. However, as a hardware simulation tool, ISS systems are insufficient.

For the above reason, when a hardware simulation is required, an RTL-based simulation becomes necessary. However, as mentioned above, simulations performed using RTL are extremely slow, so that the hardware-level simulation poses a severe bottleneck when developers try to shorten the development period of a processor.

It has become possible to use an operation level synthesis tool called a "C-to-RTL" as a tool for automating the design from the C language level. Under the design environment of processor in which starting of the automation of design progresses is changing from the RTL level to the C level, it is especially important to solve the problems of simulation and verification.

A C-to-RTL tool is a tool that receives an input of the C language description writing a specification and the clock frequency as a parameter, and outputs RTL that is composed of registers. As described above, the inputted C language description has no concept of "clock" or "cycles". In the C-to-RTL tool, according to a clock frequency provided, register assignment are performed and a solution that may satisfy the specification is found. At this point, it is necessary to assign the computation units for performing execution of the arithmetic operations and logic operations written in the specification. Here, a resource sharing and a scheduling are the major points in the synthesis tool. The resource sharing is to perform the processing in accordance with the specification provided as C language using the smallest possible computation units. The scheduling is to perform the execution order given in the specification is realized in the lowest number of clock cycles. Accordingly, it is important to evaluate and verify the performance of the C-to-RTL tool.

In an automatic synthesis of the C language into RTL, the C language specification is converted into RTL without amendment, resulting the redundant bits in the C language being reflected in the automatic synthesis.

In an application program that is used by a processor equipped with a special-purpose processor, it is possible to include special-purpose instructions, which perform special-purpose processing using a data path of the special-purpose processor, together with the general-purpose instructions. However, with a conventional ISS system, while a functional simulation can be performed, a hardware simulation is not possible. This is to say, the relationship between the numbers of clock cycles consumed when the special-purpose instruction is executed by this data path and exact timing of operation of the general-purpose instructions is unclear. By the conventional ISS system, it is only possible to verify the functions of instructions (special-purpose instructions) of such a data path.

An embodiment of the present invention may provide a new simulator that can perform a high-speed hardware simulation. The embodiment may also provide a simulator that becomes a high-speed and hardware-level simulator of execution of special-purpose instructions for a data path and of general-purpose instructions that are executed by a general-purpose processor.

Aspects of the present invention are defined in the accompanying independent claims 1, 12, 27, 34, 42 and 43.

A simulator of register-level using RTL describes hardware so that the concept of clock cycles is present. For a simulator produced using C language, there is the advantage that operations can be described without the concept of clock cycles. With the present invention, instruction sets that are subjected to an ISS simulation ay be divided on a cycle basis, so that an ISS system may be used as a tool for simulating hardware. This cycle-level ISS involves a drop in the speed of simulation compared to the case where simulation is performed for the original C language, but still makes it possible to perform the simulation with around several hundred to several thousand times the speed of an RTL-based simulator, with the same high level of results being obtained as with an RTL simulation. Consequently, the efficiency of the processor design is so improved.

The present invention may provide a method of designing a processor for an application program including a plurality of instruction sets and an instruction cycle of each of the instruction sets being performed with pipeline stages in the processor,and the design method includes a cycle-level simulating step for simulating operation of the processor controlled by the application program in cycles of the pipeline stages. The application program, in this specification, means all level of programs, including source program and object program, for defining operations of a processor using instruction sets and becomes a subject or target to the simulation.

The design method can be executed by a data processing system, which is a system including a simulator, simulator or simulation system, that simulates operation of a processor for an application program including a plurality of instruction sets performed using the pipeline stages and has a cycle-level simulating means, which is sometime explained ISS system or ISS core in this specification, for simulating operation of the processor controlled by the application program in cycles of the pipeline, thereby providing an automated design system. A simulator of the present invention can also be provided as a program or program product that simulates operation of a processor for an application program including a plurality of instruction sets that are executed using the pipeline stages and has an instruction for executing a cycle-level simulating process. This program or program product may be provided by recording on an appropriate recording medium or provided via a medium such as a computer network.

With a conventional ISS system, simulation models are described and managed in units of instruction sets. On the other hand, with the present invention, each instruction set may be divided into units the cycles of pipeline stage and managed having been converted into models in units of the cycles. This conversion of instruction sets into models in units of the cycles may be performed in the cycle-level simulating step or means. Alternatively a compiler or the like may be used beforehand to form a simulation model in which the instruction sets are divided into units of the cycles, with the resulting simulation model then being simulated. With the present invention, the execution of instruction sets in units of the cycles and other processing (such as interrupt handling) that may or may not be caused by the instruction sets can be properly managed as models. Accordingly, by performing simulation using C or another high-level language without using RTL, a cycle-based simulation of hardware can be properly performed. This means that a simulation of hardware can be performed at high speed.

The series of processing of an instruction cycle of each instruction set such as fetch, decode, execution and write back may be divided into each of processing cycles corresponding separate pipeline stages (cycles of pipeline stages) and simulated in units of the cycles. The processing in each pipeline stage of each instruction may be separately modeled. However, a reduction in the required hardware resources is achieved when processing that is common to each instruction or each pipeline stage is modeled so that it can be managed as being common to each instruction or each pipeline stage. This in turn makes it possible to develop a simulator program in a short time and at low cost.

With the present invention, when the models are produced in units of the cycles, as a rough classification two parts may be used. A first part is the description that is unique to an instruction set. As one example, this is the part in the execution cycle or stage that is one of the pipeline stages of an AND instruction where the content or function (such as the construction and/or the timing) is given. The other part is the common description that is executed in every pipeline stage of every instruction set. As one example, this may be the description that is related to the handling of interrupt signals. For this reason, one may provide a library for performing a conversion, for each pipeline stage of each instruction set before the cycle-based or cycle-level simulation, into first information that can be managed by the cycle-level simulating means (hereafter, the "ISS core") or the processing performed by the ISS core that simulates each pipeline stage. When an instruction set or a pipeline stage of an instruction set is provided, a model that can be managed by the ISS core system or the processing in the ISS core is provided using the library. Processing and models that are common to each pipeline stage are described in advance for the ISS core or the processing performed therein, so that the first information can be simulated based on second information that relates to this common processing.

When a simulation is performed according to the present invention, instruction sets may be divided into units of the cycles and the ISS system may be provided with a function for performing time management in units of the cycles. Processing and/or models for the unique part of the processing in each of the cycles for an instruction may be written in the library, while processing and/or models for common processing in each of the cycles for external signals such as interrupt handling may be written in the ISS core system. Therefore, a system that can simulate hardware using a simple construction can be provided. When an application program is supplied, according to the present embodiment, each instruction set is divided into separate pipeline stages and performs a simulation in the cycles, like when the application program is executed by a processor that is the subject of the simulation.

Also, by using a program including instructions capable of executing a process that converts each instruction set in an application program into a simulation model expressed in notation divided into pipeline stages, the application program may be converted into a simulation source that is suited to be simulated by the ISS core of the present embodiment. It makes possible to further reduce the time taken by simulation.

When the processor that is to be simulated includes a special-purpose data path, the processing that is performed using this data path has its cycles managed differently to the pipeline stages in a general-purpose processor. Accordingly, when the processor includes a general-purpose processing unit for executing general-purpose processing and a special-purpose processing unit that is dedicated to special data processing, it is preferable for a general-purpose instruction library and a special-purpose instruction library to be provided. The a general-purpose instruction library is provided for converting each pipeline stage of each general-purpose instruction set, included in the application program, that specifies processing by the general-purpose processing unit into information that can be managed by the ISS core or process therein. The special-purpose instruction library is provided for converting each special-purpose instruction set, included in the application program, that specifies processing by the special-purpose processing unit into information that can be managed by the ISS core or process therein. The general-purpose instruction sets and special-purpose instruction sets are converted using different libraries in different conversion processes (the first conversion process and the second conversion process), so that the processor having processing units the cycles are differently managed can be modeled by the ISS core. Libraries for these conversions may be provided as a single program. When different library programs are used, it is possible to establish a design environment where a library for general-purpose instruction sets is provided by a simulator provider and the library for special-purpose instructions sets is supplied by the user that designed the special-purpose processing unit.

By using a special-purpose instruction library, the processing of the special-purpose processing unit can be appropriately modeled. By providing information including a number of the cycles consumed by the special-purpose instruction sets from the special-purpose instruction library as some kind of data or signal, in the ISS core or the process therein, the execution state of the special-purpose processing unit is reflected in the simulation. Also, by providing the state of the special-purpose processing unit in units of the cycles, in the ISS system or the process therein, the execution state of the special-purpose processing unit can be reflected in the simulation.

In this way, the present embodiment provides a tool that can simulate hardware at high-speed in cycles base. Consequently, it is possible to design and provide, quickly and economically using a specification written in C, a distributed processing-type system LSI that can perform high-speed processing using special-purpose circuitry. During the designing and development of such a processor, a simulation can be performed with the concept of cycles or clocks at an intermediate stage in the transition from C to RTL. The introduction of this new design infrastructure layer increases the simulation speed, making the design process more efficient and producing various other benefits.

A first benefit is that, in the simulation for the processor controlled by general-purpose instruction sets and special-purpose instruction sets, the operation of the special-purpose processing unit (a dedicated processing unit or specialized processing unit) that is operated by a special-purpose instruction set can be simulated not at RTL level but in an environment close to C language level. In addition, the process of the special-purpose processing unit is just converted into the information handled by the cycle-based ISS core. Therefore, the information or the process of the special-purpose processing unit does not need to be written in C language, so that if a different language is more suitable for describing the operation of the special-purpose processing unit, a specification written in C may be converted into the different language before compiling to produce the special-purpose instruction library.

As one example, when the most popular language at present, ANSI-C, is used to write a specification for a processor, the data lengths of variables are restricted to 16 bits, 32 bits, and 64 bits. On the other hand, in a specification that is provided as user instructions, such data lengths are not always used, with it being common for specifications to use other lengths such as 24 bits. With ANSI-C, such specifications cannot be faithfully reproduced, so that there is the possibility of a different result being produced than for the case where the same specification is subjected to RTL simulation, meaning that in the end an RTL simulation also has to be performed. However, when another language, such as C++, is used, the data length can be varied by making type declarations for variables using class libraries. Accordingly, if a special-purpose instruction library is produced by converting a C language specification into C++ language and then compiling the result, it is possible to eradicate bit redundancies, and a simulation that is at the same level as RTL can be executed by a cycle-based ISS system.

Another benefit is that pseudo-instructions that are not executed by the processor can be added to the simulation performed by the cycle-based ISS core in order to evaluate the simulation or for other purposes. One of the important pseudo-instructions is for performing processing for which the number of the cycles is not counted by the ISS core. By providing, at a same level as the special-purpose instruction library, a pseudo-instruction library for converting pseudo-instructions into information that can be managed by the simulator, such instructions can be utilized by a cycle-based ISS system. One of the pseudo-instructions for evaluating (testing and debugging) the operation monitors designated data input/outputs.

In a simulation performed using the present cycle-based ISS, the process of simulating a processor that is equipped with a special-purpose processing unit can be divided into a number of stages. In a first stage, an ISS simulation is performed without removing the part that is executed by the special-purpose processing unit from the specification that is provided in C language or the like. If pseudo-instruction sets are introduced at this stage, input/output data and expected values or the like that are used as standards for the subsequent evaluations may be obtained. In the next stage, the part that is executed by the special-purpose processing unit is extracted from the specification and is replaced with a special-purpose instruction set. A special-purpose instruction library is generated from this extracted part, and the next simulation is performed by the ISS system. With the cycle-based ISS system of the present embodiment, a simulation that includes the special-purpose processing unit can be performed on a cycle basis, so that a large part of the development of a processor can be performed at this stage. Also, by using pseudo-instructions to compare data produced at this stage with the input/output data and expected output values obtained in advance, it is possible to develop a processor smoothly and in a short time without any large errors in the design.

Also, as a third stage, the special-purpose instruction library may be converted into RTL before another ISS simulation is performed. It is possible to verify the functioning after conversion to actual RTL, with the general-purpose processing unit also being operated by the cycle-based ISS system, so that a highly accurate simulation that is matched to the RTL can be performed.

These and other advantages and features of embodiments of the invention will become apparent from the following description thereof taken in conjunction with the accompanying drawings which illustrate a specific embodiment of the invention. In the drawings:
FIG. 1 shows a data processing apparatus (VUPU) that includes a PU and a VU;
FIG. 2 shows how a VUPU is developed based on a specification that is written in C language;
FIG. 3A and 3B show how instruction sets are executed with the processing being divided into pipeline stages;
FIG. 4A and FIG. 4B respectively show how instruction sets are evaluated in units of instruction cycles and how instruction sets are evaluated in units of the cycles when the processing of instruction sets has been divided into pipeline stages;
FIGS. 5 shows a number of cases where instruction sets are evaluated in units of instruction cycles compared to a case where the processing of instruction sets has been divided into the cycles;
FIG. 6 shows a simulator according to the present invention.
FIG. 7 shows a comparison between a model of instruction sets shown in units of instruction cycles and a model of instruction sets shown in units of the cycles of pipeline stages;
FIG. 8 shows a model of instruction sets shown in units of the cycles of the pipeline stages that has been divided into models of processing unique to each stage and a model of processing common to each pipeline stage;
FIG. 9 shows a design method in which pseudo-VU instructions have been introduced;
FIG. 10 shows how a VUPU is developed based on a specification that is written in C language and in which pseudo-VU instructions have been introduced;
FIG. 11 is a flowchart showing an ISS system and the function used as the libraries in the simulator shown in FIG. 6;
FIG. 12 shows a different example of a simulator according to the present invention; and
FIG. 13A and 13B show a simplification of a design procedure according to the present invention.

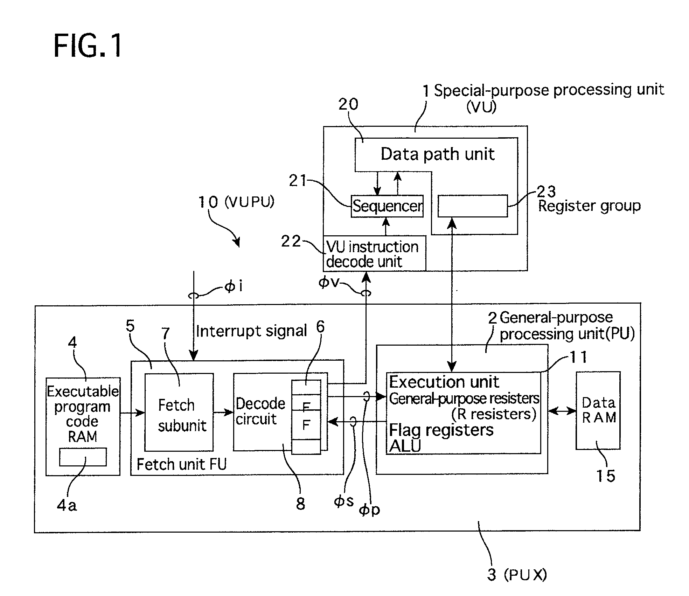

The following describes the preferred embodiments with reference to the attached drawings. FIG. 1 shows a simplification of a data processing apparatus 10 that includes a special-purpose processing unit (a special-purpose instruction executing unit or special-purpose processing unit, hereafter "VU") 1 that is equipped with a data path unit 20 that is designed so as to perform specialized or dedicated data processing, a general-purpose data processing unit (a standard processing unit, a general-purpose instruction executing unit or general-purpose instruction processing unit, hereafter referred to as the "PU") 2 that has a standard construction. This data processing apparatus 10 is a programmable processor that includes a specialized circuit, and so includes a fetch unit 5 that fetches instructions from an executable control program (object program, program code or microprogram code) 4a stored in a code RAM 4 and provides the VU 1 and PU 2 with decoded control signals. The FU 5 includes a fetch subunit 7 and a decode unit 8. The fetch subunit 7 fetches an instruction from an address in the code RAM 4 according to the previous instruction, a state of state registers 6, or an interrupt signal ϕi. The decode unit 8 decodes the fetched instruction, which may be a special-purpose instruction or a general-purpose (standard) instruction. The decode unit 8 provides the VU 1 and the PU 2 respectively with decoded control signals ϕv produced by decoding special-purpose instructions and decoded control signals ϕp produced by decoding general-purpose instructions. A status signal ϕs showing the execution state is sent back from the PU 2, and the states of the PU 2 and the VU 1 are reflected in the state registers 6.

The PU 2 is equipped with a general-purpose execution unit 11, which includes general-purpose registers, flag registers, and an ALU (arithmetic logic unit), etc., and is constructed so that general-purpose processes can be executed one after the other while the execution results are being outputted to a data RAM 15. In other words, a standard instruction set is executed in the PU 2 by dividing the required processing into a plurality of pipeline stages, such as a fetch and decode stage, an execution stage, and a write stage that writes an execution result into a memory. A construction that includes a fetch unit (FU) 5, a PU 2, a code RAM 4, and a data RAM 15 resembles a standard processing unit, though the functioning of these components are different. For this reason, a construction composed of the FU 5, the PU 2, the code RAM 4, and the data RAM 15 can be referred to as the "processor unit 3", so that it is possible to construct or design the data processing apparatus 10 of the present embodiment so that the processor unit (PUX) 3 controls the VU 1.

As mentioned above, the VU 1 executes a special-purpose instruction ϕv that is received from the FU 5. To do so, the VU 1 includes a unit 22 for performing decoding so as to recognize whether an instruction supplied by the FU 5 is the special-purpose instruction (hereinafter decoded signals and the instructions are sometime described as the same) ϕv, a sequencer (finite state machine or "FSM") 21 that outputs, using hardware, control signals that have predetermined data processing performed, and a data path unit 20 that is designed so as to perform the predetermined or dedicated data processing in accordance with the control signals received from the sequencer 21. The VU 1 also includes a register 23 that can be accessed by the PU 2. The data that is required by the processing of the data path unit 20 is controlled and/or supplied by the PU 2 via an interface register 23, with the PU 2 being able to refer to the internal state of the VU 1 via this interface register 23. The result produced by the processing performed by the data path unit 20 is supplied or announced to the PU 2, with the PU 2 using or referring to this result to perform further processing.

The data processing apparatus 10 has a program including general-purpose instructions (called "PU instructions") and special-purpose instructions (called "VU instructions") stored in the code RAM 4. These instructions are fetched by the FU 5 and control signals ϕp or ϕv produced by decoding these instructions are supplied to the VU 1 and the PU 2. To the VU 1, both of the control signals ϕp and ϕv are supplied and out of the control signals ϕp and ϕv, the VU 1 operates when it is supplied with the control signals ϕv that represents the special-purpose instruction executed by the VU 1. On the other hand, the PU 2 is designed so as to be supplied with only the control signals ϕp produced by decoding a general-purpose instruction. The PU 2 is not supplied with control signals ϕv produced by decoding a VU instruction and instead is issued with control signals indicating a NOP instruction that does not cause the PU 2 to operate. In this way, processing by the PU 2 can be skipped.

The VU 1 may be changed depending on factors such as the application to be executed, with the special-purpose instructions to be executed by the VU 1 also changing depending on the application. This is to say, the VU 1 is a specialized circuit that is suited to a certain application, with it being easy to design the circuit so as to interpret control signals produced by decoding a VU instruction. On the other hand, a NOP instruction is outputted to the PU 2 since the PU 2 does not need to handle the specialized instructions for which the VU 1 is designed. The PU 2 only needs to be able to execute basic instructions or general-purpose instructions, so by applying a PU 2 alongside VU or UVs 1, a system suited to various applications can be supplied without the processing performance for standard procedures being affected. In such a system, by the PU 2 or PUX 3 controls the VU or VUs 1 and can use the processing results of the VU or VUs 1 in other processing.

The data processing apparatus 10 shown in FIG. 1 has a VU 1, which is equipped with a specialized circuit for the specialized processing (such as that required for real-time response), and a PU 2, which is a general-purpose component, with this kind of data processing apparatus being referred to hereafter as a "VUPU" device. The VUPU 10 has the merits that it can be designed and produced in a short time without affecting the real-time response capability of the processing unit, and it can cope with adjustments and corrections that are made at a later date or stage. The present construction is not restricted to including only one VU 1. Instead, a plurality of VUs 1 can be provided and the program code can include a plurality of special-purpose instructions that are executed by the respective VUs 1 for realizing specialized processing required by an application. Also, the VU 1 does not need to just perform specialized computations, but can be provided as a specialized circuit for a specific program function in the program. This makes it possible to execute the program efficiently. By having such architecture, a data processing system that has a plurality of VUPUs 10 can be adapted to an extremely wide range of uses.

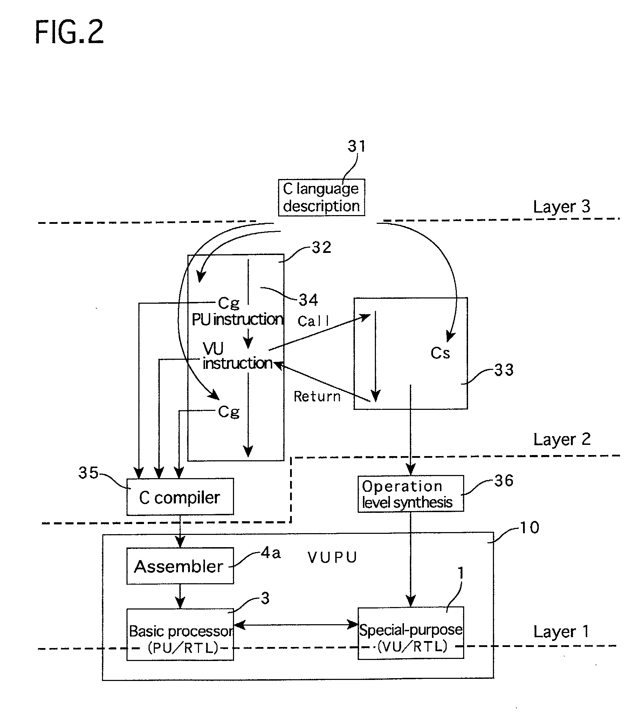

FIG. 2 shows the flow of the procedure used when designing a processor with this architecture. In order to execute a specification written in C language or an application program 31, specific process in the program and/or a program function Cs, that is a specification part of the specification, are converted into dedicated circuits to raise the efficiency with which the program is executed. In more detail, a specification 31 is divided into another application program 32 that is written in C language and a function 33 that is converted into dedicated circuit, with the application program 32 of this level including (i) a part Cg 34 composed of instructions (PU instructions) that perform general-purpose processing and (ii) instructions (VU instructions) that activate the dedicated circuit. The application program 32 is converted by a C-compiler 35 into assembler instruction sets that can be executed by a processor, resulting in the generation of executable program code 4a. On the other hand, the operations that are required for the processing in the extracted program function 33 are analyzed (operation level synthesis 36), and a special-purpose data path or dedicated circuit is designed and produced. By doing so a VUPU 10, which is equipped with a VU1 and a basic processor PUX 3 can be generated along with the program code 4a to be executed by this VUPU 10.

If RTL in which the functions of the PUX 3 have been modeled and RTL in which the functions of the VU 1 have been modeled were generated, the operation of the assembler or object level program code 4a (hereafter sometimes referred to also as the "application program") for the developed VUPU 10 is simulated by the generated RTLs as a platform. In this specification, the application program means all level of the programs for instructing and/or defining operations of a processor using instruction sets and becomes the subject or target to the simulation. Since simulations that use RTL are extremely time-consuming, this method is not realistic. On the other hand, when simulations are performed at the assembler level, which is to say, at the instruction set level, the functioning of the program 4a can be checked, though it is not possible to simulate the actual changes in the state of the VUPU 10 in each cycle or in each clock cycle. This is a first problem.

A second problem is that a data path instruction (VU instruction) for executing the processing that has been converted into dedicated circuitry in the form of a VU 1 is an instruction for detecting a specific data pattern among signals during image processing or network processing. The number of cycles consumed by this kind of instruction exhibits a data dependency, so that the number of cycles cannot be known in advance. This means that it is still difficult to perform simulations using a simulator that uses RTLs as platform.

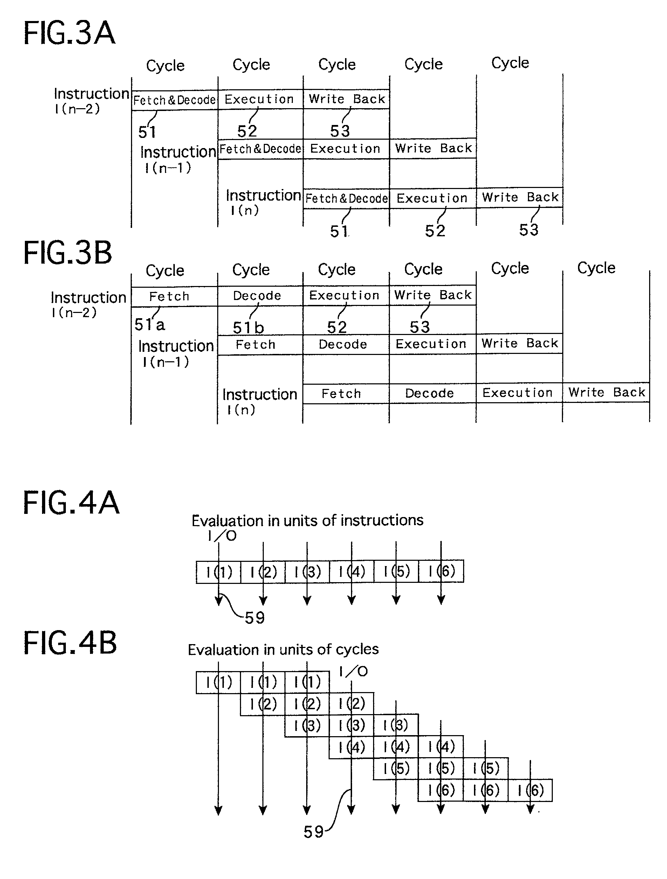

The first problem is that, as shown in FIG. 3A, in the PUX 3, which is the basic processor, processing is performed with the instruction cycle for a single instruction set, such as an "ADD". The instruction cycle is divided into a plurality of pipeline stages. FIG. 3A shows the instruction cycle of a three-stage-pipeline RISC processor. A single instruction set is processed by a plurality of divided processing consists of a cycle ("F&D cycle") 51 where fetching and decoding are performed, a cycle (execution cycle) 52 where execution is performed, and a cycle ("WB cycle") where a result is written back into memory. Also, as shown in FIG. 3B, in a four-stage-pipeline RISC processor, instructions are executed with the F&D cycle 51 being subdivided into a fetch cycle 51a and a decode cycle 51b. For ease of understanding, the following explanation describes an example where a three-stage-pipeline RISC processor is used as the basic processor PUX 3. In this case, the F&D cycle 51 of an n^{th} instruction I(n) is simultaneously performed with the execution cycle 52 of an (n-1)^{th} instruction I(n-1) and the WB cycle 53 of an (n-2)^{th} instruction I(n-2).

FIG. 4A shows an instruction model of a conventional instruction set simulator (ISS). In this model the first instruction set I(1) to a sixth instruction set I(6) are processed in order. Provided that each instruction set is executed in accordance with the functioning of that instruction set, there are no particular problems. However, in order to evaluate the processing when an I/O 59 occurs for the PUX 3 from the periphery or from the VU 1, the state at that point becomes uncertain. When each instruction set is divided into three pipeline stages as shown in FIG. 4B, each instruction set is processed in units of the cycles (units of clocks) with a partial overlap with other instruction sets. When I/Os 59 are added with the instruction sets having been expressed in clock cycles, it becomes possible for I/Os to occur at eight different times for an actual processor, as shown in the model in FIG. 4B, as opposed to only six different times in the model in FIG. 4A where I/Os 59 are shown as occurring for each instruction. Depending on the timing at which an I/O occurs, there is the possibility of the subsequent processing changing.

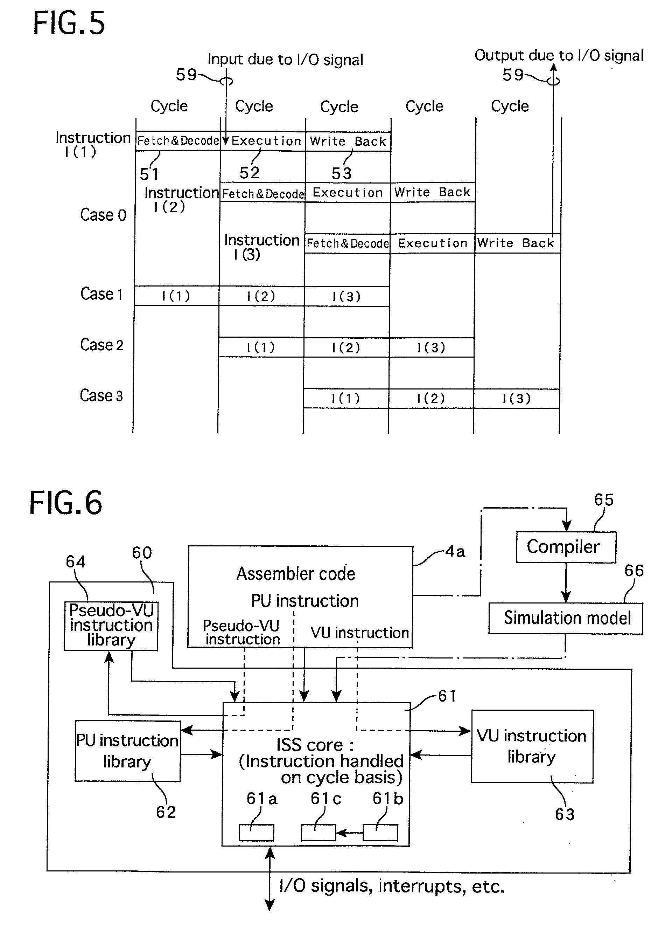

As one example, the processing shown in FIG. 5 shows the operation that is performed when an input signal 59 is generated by an I/O operation during the second cycle from the start of the processing. In case 0 of FIG. 5, an I/O signal 59 is inputted during the execution cycle 52 of the first instruction I(1), processing is performed using the second instruction I(2), and then the result is outputted by the I/O signal 59 by the WB cycle 53 of the third instruction I(3). On the other hand, case 1 of FIG. 5 is a model where the processing is shown in instruction units and the start of each instruction is aligned with the F&D cycle 51 of the instruction. In the case 1, the second instruction I(2) is incapable of catching an I/O signal, so that the processing described above cannot be realized. In case 2 of FIG. 5, the start of each instruction is aligned with the execution cycle 52 of the instruction. While it is possible for an I/O signal 59 to be received during the execution of the first instruction and for a result of processing performed using the second and third instructions to be outputted via another I/O signal 59, the timing at which the signal is outputted by the third instruction differs from the processing described above. In case 3 of FIG. 5, the start of each instruction is aligned with the WB cycle 53 of the instruction. In this case, the second instruction 1(2) is incapable of sensing that an I/O signal 59 has been inputted.

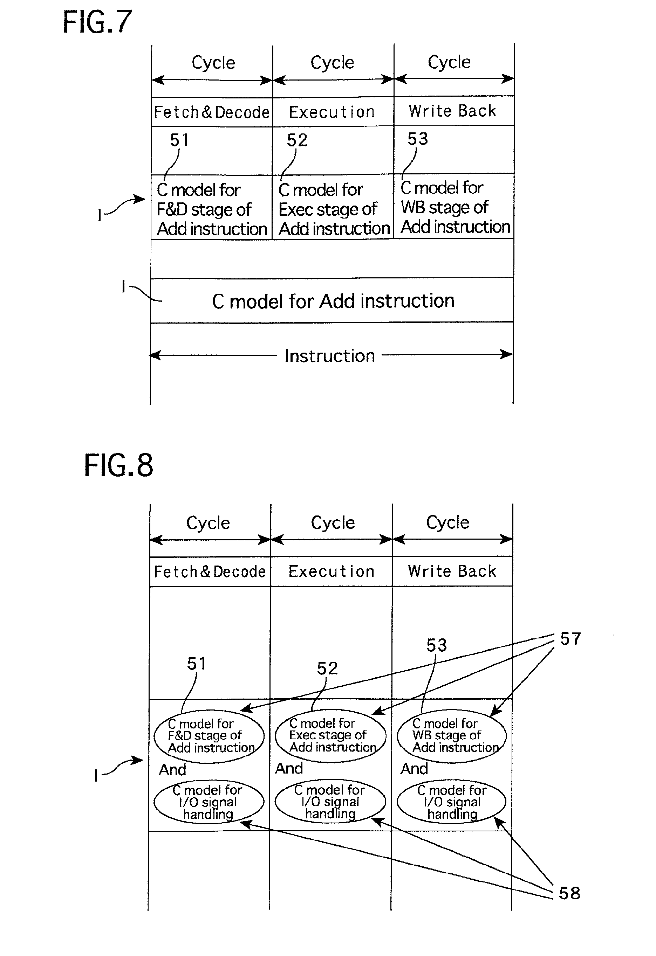

In this way, since I/O signal 59 and interrupts all occur in synchronization with the clock or on a clock cycle basis, to properly handle such signals it is necessary to use a model that divides instructions on the cycles basis. For this reason, as shown in FIG. 6, the present invention provides a simulator 60 that is equipped with an ISS core system 61 that can manage the processing in units of the cycle, thereby making it possible for simulations to be performed based on an instruction model where instructions are divided on the cycles of pipeline stages. Putting this another way, as shown in FIG. 7, in a conventional ISS system the functioning of instructions is modeled in units of the instructions I using C language. Conversely, with the simulator 60 of the present invention, each instruction set I is modeled in units of the cycles, which is to say, each instruction is divided into a F&D part or stage 51, a execution part or stage 52, and a WB part or stage 53, and the resulting pipeline stages are modeled using C language. After this, the processing is simulated by evaluating each cycle of each instruction I using the ISS core 61. This means that when processing is simulated for a three-stage pipeline RISC processor, three instruction sets are normally evaluated in each cycle. While this results in the simulation being slower than when a conventional ISS system is used. However, instead of simulating assembler code on a conventional C language simulator, it is possible to simulate how processing is actually performed on hardware by an application program 4a that is written in assembler code.

As shown in FIG. 8, when instruction models in cycle units are managed by the ISS system 61, the processing may be expressed using a C language model (first information) 57 produced separately for each pipeline stage of each instruction set and a C language model (second information) 58 that is common to each stage of each instruction set. As one example, by describing a model relating to I/O signals for each cycle as the common model, it is possible to correctly simulate the operation related to I/O signals with respect to cycle boundaries. However, when this method is used, there is an increase in the amount of notation for this shared second information. For this reason, in the ISS simulator 60, the ISS core 61 is provided with a mechanism or section 61a for managing time in units of the cycles so that the simulating can be performed in cycles base or level, a section 61b in which the second information (for processing that responds to I/O signals, etc.) that is common to cycles or pipeline stages is written, and a mechanism or section 61c for responding based on this second information.

Also, once an instruction set I is decided, the model (first information) that is unique to each pipeline stage of this instruction set is also decided. This means that the simulator 60 of the present embodiment is equipped with a PU instruction library 62 that provides a model for each pipeline stage in each instruction set, with each pipeline stage of each instruction set being replaced with a model that can be managed by the ISS core 61 (i.e., first information). This makes it possible to simulate an application program in cycle level even if the application program only has information of instruction set level when the application program is supplied to the simulator 60. Also, even when the simulation model used has descriptions divided in units of the cycles, it is still possible to reduce the amount of notation in the simulation model using the PU instruction library 62.

In the simulator 60 shown in FIG. 6, the ISS system 61 refers to the PU instruction library 62 and constructs a simulator model in units of the cycles based on an application program 4a written in assembler code, so that simulation is performed with the processing being managed in cycle level. In order to reduce the load of the ISS system 61 and increase the execution speed, it is preferable to use a compiler or compiler program 65 that converts the assembler codes (instruction sets) into codes that is divided into pipeline stages and make a simulation model 66 in which instruction sets are expressed in units of the cycles in advance.

The simulator 60 is also equipped with a VU instruction library 63 that provides the processing performed by the VU 1 when activated by a VU instruction as information that can be managed in units of the cycles by the ISS core system 61. By defining the number of the cycles that are consumed by VU instructions in the VU instruction library 63, it is possible to solve the second problems described above, which is to say, the inability to know the number of cycles used or consumed by when a VU instruction that detects a specific bit pattern from a signal stream as part of image processing or signal processing is executed. Therefore, present simulator 60 can simulate PU instructions in cycle level by managing a model for each pipeline stage that is supplied by the PU instruction library 62 and simulate the number of cycles consumed by the VU 1 using the VU instruction library 63.

By operating in this way, the simulator 60 can completely simulate the I/O and interrupt processing of the VU 1 and PU 2 internally for the VUPU 10, as well as the I/O and interrupt processing for the periphery in cycle or clock units using C language. This makes it possible to provide a simulator that can simulate the operation of hardware at high speed.

The simulator 60 of the present embodiment is provided with a PU instruction library 62 and a VU instruction library 63 that are separate. The PU instruction library 62 is a library that enables the processing of the basic processor PUX 3, which is an embedded processor for realizing the VUPU 10, to be expressed in units of the cycles, and so has a largely fixed content.

On the other hand, the VU instruction library 63 reflects the processing of the VU 1 that can change depending on the user specification for the VUPU 10 that is to be realized, so that there is a high probability of changes to the content of this library. Accordingly, the VU instruction library 63 is provided separately for each user and/or can be designed by the user himself/herself, so that user specifications can be used with little effect on the simulator 60. By using the construction of the present embodiment, a simulator 60 for simulating a VUPU 10 can be developed economically in a short time.

The VU instruction library 63 of the present embodiment is produced by converting a part of a specification or a program function Cs that is written in C language into C++ language, or by compiling such a part with C++. This means that by making type declarations for variables, the data length that can be handled is variable, so that redundant bit lengths that are present when code is written in C language can be eradicated. Therefore, the VU instruction library 63 becomes replaceable to the RTL that realizes the actual hardware function of the VU 1. Accordingly, a VUPU 10 can be simulated more accurately, with more realistic conditions, and at higher speed than with an RTL simulator. If the ISS system 61 is equipped with a C language compiler or a C++ language compiler, the VU instruction library 63, like PU instruction library 62, may be a library that is written in C language or C++ language, though if a compiler is not provided in the ISS system 61, such libraries need to be compiled in advance.

The simulator 60 also includes a pseudo-VU instruction library 64 for virtual instructions that cannot or will not be executed by a real processor. These pseudo-instructions are mainly used for evaluation purposes and are treated in the same way as VU instructions, so that there are called "pseudo-VU instructions" in this specification. Pseudo-instructions provide processing that inputs data into the ISS system 61 or outputs expected values in order to evaluate the progress or result of the simulation. During the process performed owing to the pseudo-VU instructions, the simulation of the VUPU 10 is suspended. In other words, the counting of the number of cycles by the ISS system 61 is stopped, so that the pseudo-VU instructions are executed in zero cycles in the simulation of VUPU. This pseudo-VU instruction library 64 can be thought of as providing special-purpose instructions that consume zero cycles for the simulation of PU instructions, so that the pseudo-instruction library 64 may be treated within the simulator 60 in the same way as the VU instruction library 63. Accordingly, the simulator 60 can be equipped with a pseudo-VU function for debugging purposes in addition to a normal VU. An actual processor 10 also handles such instructions as pseudo-VU instructions, so that when a pseudo-VU instruction (an "E instruction") is fetched, only a NOP instruction is outputted to the PU 2. Since such instructions are not VU instructions for the VU 1, the VU 1 does not perform any processing. This means that there is no particular need to delete such instructions once the simulation has been completed.

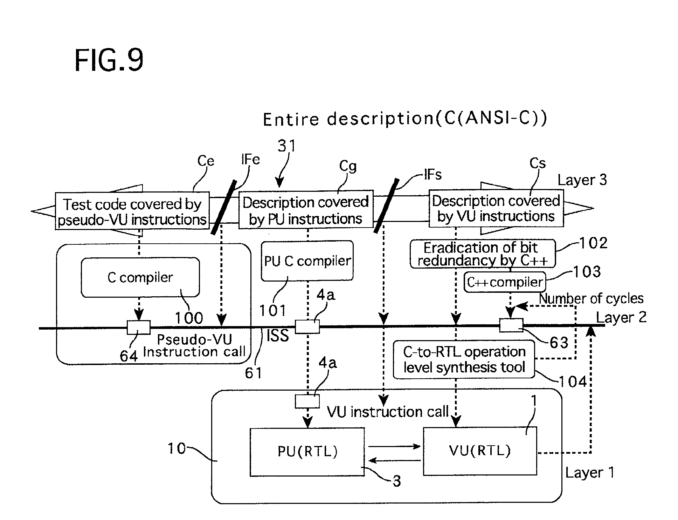

FIG. 9 is a representation of the design method used when such pseudo-VU instructions have been introduced. Here also, it is possible to use the concept of layers consist of a third layer (layer 3) where the entire description 31 is described in C language, a second layer (layer 2) where simulations are performed by simulator 60 achieved by a cycle-based ISS system, and a first layer (layer 1) where a VUPU 10 is provided. FIG. 9 shows the effect of introducing a simulation (layer 2) realized by a cycle-based ISS system 61 between the C language (layer 3) and the VUPU 10 (layer 1) that is realized by RTL. In the present example, the entire description 31 that is realized by C language (assumed to be ANSI-C) includes test codes for test processes such as inputting data file, comparing output values with expected values. If the debugging through observation can is effective, one of the test codes defines a function such as a graphical output routine.

The test code part Ce among the total C description shown in FIG. 9 is not mapped on a VUPU 10 that is produced in silicon, and is provided in the form of pseudo-VU instructions that are only executed by the ISS system 61. The part covered by the pseudo-VU instructions (part Ce), like the part that is covered by the VU instructions (part Cs), is extracted from the C language description 31, is compiled by a C language compiler 100, and is installed in the simulator 60 that runs the ISS system 61 in the form of a pseudo-VU instruction library 64 or a pseudo-VU instruction library object. Accordingly, the pseudo-instruction library 64 is the output of a C compiler 100 run on a computer system or environment on that the ISS system 61 also runs. An interface IFe between the part Cg to be covered with PU instructions and the part Ce corresponds with the pseudo-VU instructions.

As described earlier with reference to FIG. 2, the part Cg that is described using PU instructions is the part of the C language description that to be performed by the basic processor PU 2. The part Cg is converted to a simulation level program 4a that is executed by the ISS system 61 by compiling with a C compiler 101 for PU purposes. This simulation level program 4a is converted into a binary program that is used as an object program of the VUPU 10 when the basic processor PU provided in RTL format.

The part Cs that is to be covered by VU instructions is extracted from the entire description 31. When the part Cs has bit redundancy, the C language description is converted into a C++ description and the redundancy is eradicated (using class libraries) by making type declarations of variables, resulting in a library 102 with an optimized bit description. After this, compiling is performed by a C++ compiler 103 to generate a VU instruction library 63 that is embedded or installed in the simulator 60. The interface IFs between the part Cg covered by PU instructions and the part Cs is realized by VU instructions as is in the VUPU 10.

The C++ language library 102 from which the bit redundancy has been eradicated is converted again into C language that is stipulated as an input style of a C-to-RTL operation level synthesis tool 104. This converted into C language description is set as the input for operation level synthesis. The C-to-RTL tool 104 usually reports the converted RTL and the number of cycles consumed in the RTL. The VU instruction library 63 receives the reported number of cycles from the tool 104 and supplies the ISS system 61 with information having the C++ language function of the VU 1 in which the bit redundancy has been removed and the number of cycles consumed in the VU 1, thereby making it possible to perform a simulation on a cycle basis for the VU 1 accurately.

The designing process proceeds in this way, with it also being possible to perform a simulation with the RTL for the VU 1 that is finally generated being linked with the ISS system 61. This is effective as a verification phase at the last stage in the design process.

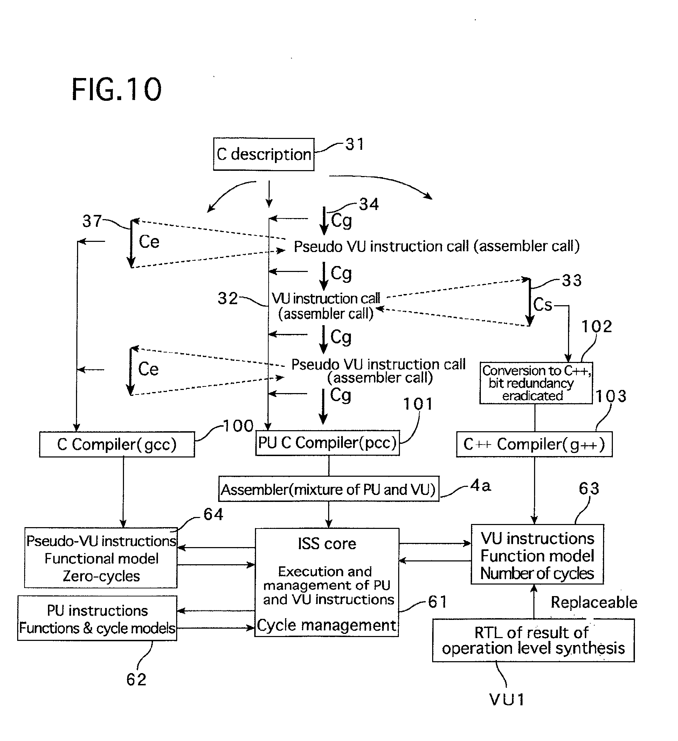

FIG. 10 shows the process of an ISS simulation on a cycle basis where a C language description 31 including pseudo-VU instructions is divided up. In FIG. 10, one part of the entire description 31 is replaced with two pseudo-VU instructions and one VU instruction. As one example, the first test code 37 that is replaced with the pseudo-VU instructions instructs opening a test file and reads test data and the second code instructs comparing an outputted result with an expected value. Also, as one example, the part 33 that is replaced with a VU instruction is a part of C language description for signal processing that is preferable to speed up by using dedicated hardware. The other part 34 is converted into the PU instructions to be executed by standard software processing, so that a program 32 that includes PU instructions, VU instructions, and pseudo-VU instructions is generated. This program is compiled by a PU compiler 101. In the program 32, the VU instructions and pseudo-VU instructions are written by assembler calls, so that the result of the compiling is a program 4a in that PU instructions and VU instructions (including pseudo-VU instructions) are listed and mixed. The instructions in this mixed list 4a are successively read by the ISS core 61 and executed.

The test code 37 should preferably be provided as pseudo-VU instructions that are executed by only the ISS core 61. Because the test code is only required for simulating and debugging, and is normally not converted into hardware. Accordingly, the number of cycles of the pseudo-instructions to be consumed in the simulation core 61 shall be set at zero and only the test function to be executed without counting the cycles. The test code 37 is compiled suitably by a compiler 100 for running on the computer environment by which the ISS system 61 has been developed and on which the ISS system 61 runs. As one example, if the ISS system 61 is run on a particular OS (operating system), the test code is compiled by a C language compiler (such as the freeware compiler "gcc" that runs on the Sun Microsystems' OS) that runs on that OS, and is provided to the ISS system 61 as a pseudo-VU instruction library 64. The pseudo-VU instruction library 64 provided in the ISS system 61 is called and returned from the PU according to a pseudo-VU instruction, in the same way as with a VU instruction, with the processing returning thereafter.

The C language description 33 for VU instructions that are converted into hardware as special-purpose instructions are instructions that can be defined by the user when developing a VUPU processor, and are provided in the form of a VU instruction library 63 using the method described above. By being provided with a pseudo-VU instruction library 64 and a VU instruction library 63 in this way, the ISS system 61 can read the instruction sets in the assembler code 4a in order and then perform processing by reading the PU instruction library 62, which is provided in advance as cycle-level models, in the case where the read instruction set is a PU instruction or by reading the VU instruction library 63 in the case where the read instruction set is a VU instruction. In the same way, when the read instruction set is a pseudo-VU instruction, the ISS system 61 performs processing having read the pseudo-VU instruction library 64.

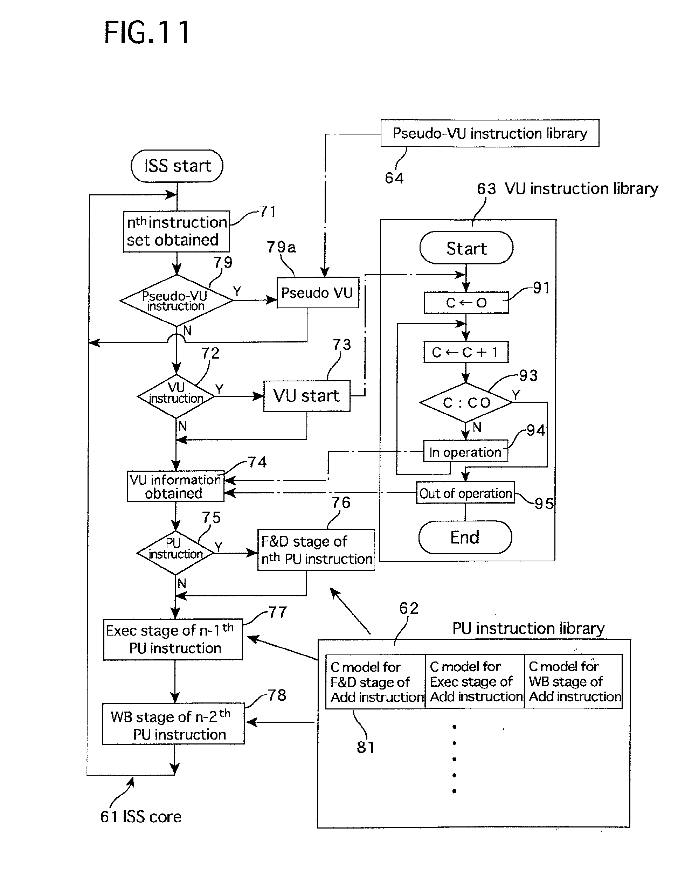

FIG. 11 is a flowchart showing the main processing of a program for realizing the simulator 60. Once the program for realizing the ISS system 61 has started, in step 71 the n^{th} instruction set in the application program 4a that is to be simulated is obtained. In step 79, if this instruction set I is a pseudo-VU instruction, the processing that activates a pseudo-VU is performed in step 79a. The pseudo-VU is a VU that can be operated only by the ISS core system 61. As described above, an I/O or other processing for debugging purposes is performed by referring to the pseudo-VU instruction library 64.

During the processing of the pseudo-VU, cycles are not counted, so that when the step of the pseudo-VU instruction ends or carries out, the other simulation steps are not performed. The procedure returns to step 71 so that the next instruction set is fetched. In this way, the states of the VU 1 and the PU 2 can be evaluated without affecting these states without counting the cycles. In addition, the pseudo-VU instructions can be introduced into the program code 4a at the same level as the VU instructions and PU instructions, so that the timing and/or states that are evaluated by the simulation can be stipulated in the same program level. This means that the evaluation performed by the simulation is performed efficiently and easily in the present simulator.

If, in step 72, the present instruction set I is a VU instruction, in step 73 the processing that starts the VU 1 is performed. As shown in FIG. 11, if the program that supplies functions as the VU instruction library 63 is a program that only counts the number of the cycles consumed in the VU 1, in step 73, the count number C is cleared and then counting is commenced.

A program representing the VU instruction library 63 includes a step 91 that initializes the count number C, a step 92 that increments the count number C at timing that is determined by the length of a cycle, a step 93 that judges whether the count number C has reached a value C0 at which the processing by the VU 1 ends, a step 94 that provides the ISS system 61 with information showing that the VU 1 is currently operating if counting is presently being performed, and a step 95 that provides the ISS system 61 with information showing that the VU 1 is currently stopped if the counting has ended. The program of the ISS system 61, following the step 72, in step 74 it is possible to make an enquiry to the VU instruction library 63 for managing or getting the information including the state of the VU 1 in the present (enquired timing) cycle.

In step 75, if the obtained instruction set I is a PU instruction, the ISS system 61 advances to step 76 where the ISS system 61 obtains a model (first information) of the F&D cycle or stage of the n^{th} PU instruction among the C language models 81 that are provided in the PU instruction library 62, and executes the model that is unique to show that stage. At the same time, the ISS system 61 executes the model (second information) that is common to every stage and deals with processes such as external I/Os or I/Os to or from the VU. Before, after or parallel this, in step 77 the ISS system 61 obtains a model for the execution cycle or stage of the n-1^{th} PU instruction among the C language models 81 in the PU instruction library 62 and executes the model that is unique to that stage along with the model that is common to every stage. Also, in step 78, the ISS system 61 obtains the model for the WB stage of the n-2^{th} PU instruction from the C language models 81 of the PU instruction library 62 and executes the model that is unique to that stage along with the model that is common to every stage.

In this way, in the present simulator 60, the ISS system 61 executes models for the different pipeline stages of the n^{th}, the n-1^{th} and the n-2^{th} instruction sets for simulating the processing of a single cycle. This means that the simulator 60 can perform a simulation model that is divided into cycles of pipeline stages through the cycle-based simulation by the cycle-level ISS core system 61. In this way, the same cycle-based accuracy of a conventional simulator based on RTL can be achieved though a high-speed simulation executed in C language. This makes it possible to provide a simulator that can perform simulations of hardware at several hundred times the speed of the conventional simulator.

A library program supplies the PU instruction library function 62, which provides processing that converts each pipeline stage of each instruction set into information (i.e., models) that can be managed by a simulation program that supplies functions as the ISS system 61. By the library programs, it is possible to obtain models for managing each pipeline stage just before doing the simulation of each pipeline stage without describing the information of each pipeline stage in the simulation model of the application program. Therefore, it is possible to make a large reduction in the amount of code in the application program supplied as a simulation model. Instead of obtaining a model for each pipeline stage just before execution, as in the example described above, it is also possible for all of the models for simulating each instruction or all of the models for simulating each cycle to be obtained simultaneously. As another alternative, every model for every pipeline stage may be obtained from the libraries in units of application programs so that a simulation model having all of the pipeline stages can be generated in advance.

Furthermore, in the simulator 60, a model relating to the processing that is common to every pipeline stage is provided to the ISS system 61 and is executed in units of the cycles together with the models for each pipeline stage. Using this method enables a reduction to be made in the amount of description of the models in each stage, though it is also possible for models that include the common processing to be provided as the PU instruction library 62.

The simulator 60 is provided with the VU instruction library 63 in addition to the PU instruction library 62. When, as is the case with a VUPU 10, a processor is equipped with a special-purpose processing unit VU 1 that is a dedicated data path, the number of cycles consumed in the VU 1 by the VU instruction can be counted by the VU instruction library 63, even when there is a data dependency for the number of cycles consumed by a VU instruction in the VU 1, with the result of this counting being supplied to the ISS system 61. The state of the VU1 can therefore also be converted into information that can be managed in cycle units within the ISS system 61. A variety of methods may be used to inform the ISS system 61 of the state of the VU 1 that is simulated by the VU instruction library 63, such as by having the ISS system 61 request the VU instruction library 63 of the cycles and having the VU instruction library 63 return a counting result of the number of cycles, or by having the VU instruction library 63 inform the ISS core system 61 of the end of processing in the VU 1 so that the number of cycles can be resultantly managed in the ISS core 61.

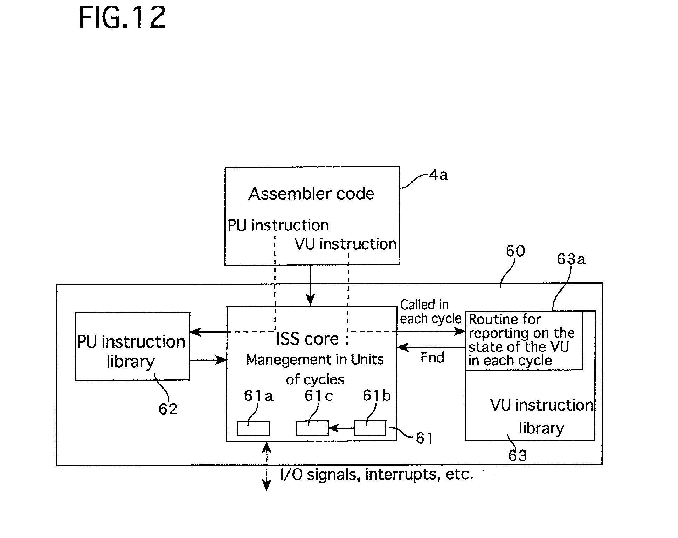

In the simulator 60 shown in FIG. 12, the VU instruction library 63 is provided with a routine 63a that informs the state of the VU 1 in each of the cycles of the ISS core 61. In this case, the state of the VU 1 is monitored in the ISS core 61 in units of the cycles, with it being possible to manage the VU 1 in cycle-level by counting the number of cycles until the processing is completed in the ISS core 61. As a result, only information showing the end of processing by the VU 1 is sent from the VU instruction library 63 to the ISS core 61, with it being possible to have the counting of the number of cycles performed by either of the ISS system 61 and the VU instruction library 63 that is on the data path instruction side. It should be obvious that the state of the VU 1 that is supplied from the VU instruction library 63 to the ISS core 61 is not restricted to such processing end information, so that it is also possible to perform an even more accurate simulation by having the ISS core 61 informed of the midway progress of processing by the VU 1 that affects the processing of PU instructions. Also, while the simulator 60 of FIG. 12 is not provided with a pseudo-VU instruction library, even when such a pseudo-VU instruction library is not used and an RTL model is not used by a cycle-based ISS core system 61, it is still possible to achieve the same level of simulation several orders of magnitude times faster.

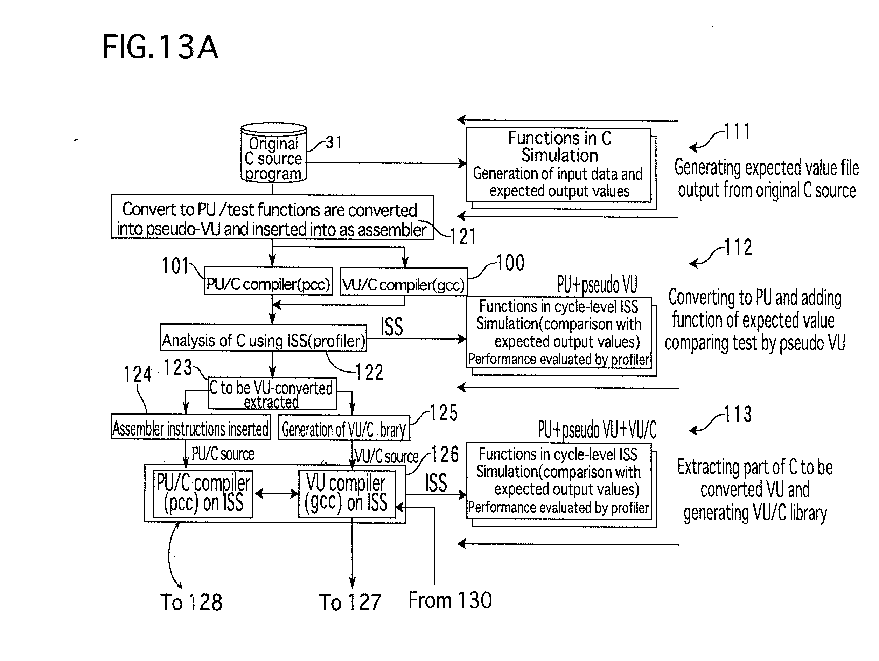

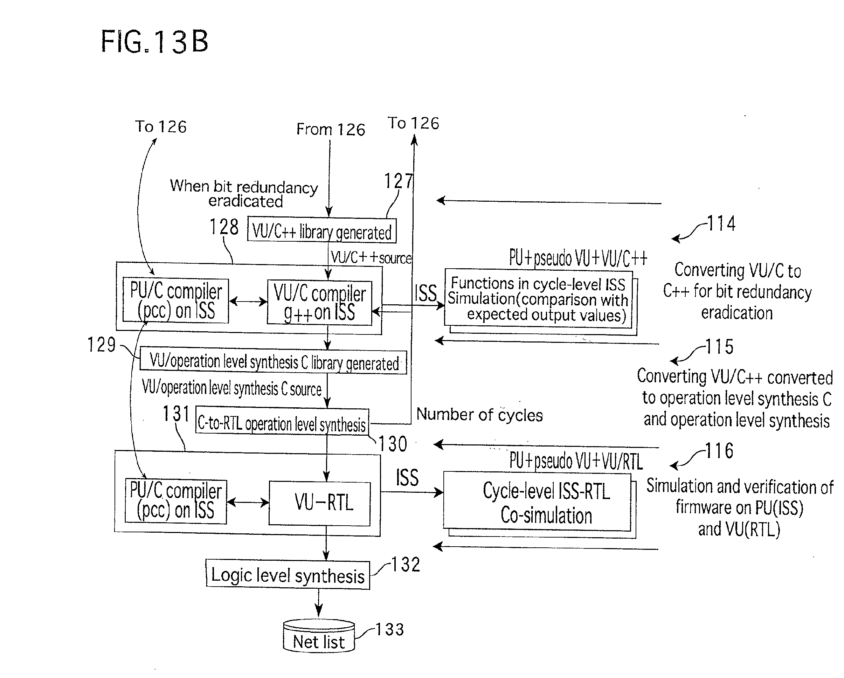

FIG. 13A and FIG. 13B show the design procedure according to the present invention in more detail. A system or program that is equipped with means or processes that are capable of executing this procedure may be provided as an automatic design system or automatic design program that operates on a suitable computer environment and those are included in the claims of this invention. The present invention can provide an automatic design system for developing or designing a system LSI from a high-level language such as C language or JAVA (registered trademark).

In the first stage 111, output expected values are produced by the C language description 31 in which the original specification is written. The expected output values are set as the basis for the test function in the latter part of the design operation. The compiler used in this design stage is a general purpose C language compiler (gcc).

Next in stage 112, the C language description 31 is converted into the PU. To do so, the C language description 31 is compiled using pcc 101 that is a C language compiler for the PU 2 (PUX 3). At this point, in the step 121, test code for performing a comparison with the output expected values can be added as pseudo-VU instructions to the program to be compiled by the pcc 101. Pseudo-VU instructions added to the program are compiled by the pcc 101 together with the other instructions, though the functions or specification (pseudo-VUs) that are executed by these pseudo-VU instructions, namely the functions of the test code, are compiled by the general purpose C language compiler (gcc) 100 to generate a pseudo-VU library.

In this way, the program (C language description) that includes a test function or functions (pseudo-VUs) that operate according to pseudo-VU instructions is verified in step 122 using the ISS system 61. The test functions are ported with the pseudo-VU instructions, so that it is possible to immediately judge whether the test functions have been properly ported in the program that has been compiled by the pcc 101. In the design stage 112, using how many clocks are consumed in what parts of the C language source code reported by the ISS system 61 as an ISS profiler, it is possible to investigate what parts of the code can be speeded up through conversion to VUs (i.e. conversion to hardware). So, which parts of the code are to be realized by VUs is judged.

Next, in design stage 113, a part or parts to be realized by VUs are extracted and conversion it/them to VUs 1. Therefore, a VU instruction library is generated in this stage 113. To do so, in step 123, the part to be converted to a VU is extracted, and in step 124, extracted part is replaced with a VU instruction. Thus, a program that is composed of VU instruction(s), PU instructions, and pseudo-VU instruction(s) is generated and the program is compiled by the pcc 101. In step 125, the extracted part is converted into a library. Since it is possible to generate a VU instruction library that can run on the ISS system 61 without changing the language from C language, a simulation step (step 126) may be inserted at this stage, though such simulation may be skipped if not required, with only the simulation in the latter stage of the processing being performed. It should be noted that the compiler that is used so as to utilize the VU instruction library in step 126 may be a general-purpose C language compiler, such as "gcc". At this stage also, the pseudo-VU instructions are used in the state of the original test code.

In design stage 114, C++ language is used in step 127 for eradicating redundant bits. With the C++ language VU instruction library 63 of step 127 that results from this eradication being installed in the simulator 60, ISS 61 runs in step 128 to confirm the number of consumed cycles. To do so, it is necessary to know the number of cycles consumed in the VU 1, so that stage 115 is executed next to find out the number of cycles and provide this number as feedback to the VU instruction library 63. As this stage also, the pseudo-VU instructions are used in the state of the original test code.

As described above, the data length in ordinary C language is 32 bits fixed, for example, and the algorithm for realizing the specification is developed and verified within the 32-bit length condition. However, in a very large number of cases, the hardware system that is used in reality does not need 32 bits, because a failure to eradicate the redundancy results in the production of execution circuits with useless hardware. This means that the eradication of redundancy using a different language (in the illustrated case, C++ language) to C language in the stage 114 is extremely important.

It is also important to perform the verification using the C++ language library 63 that the redundancy has been eradicated. It is necessary to verify through simulation that the eradication of redundancy has not gone too far, so that it is very important that this verification can be performed using a cycle-based ISS system 61 in the stage 114. Putting this another way, if there were no cycle-based ISS system 61, it would only be possible to perform a simulation on an RTL-basis that takes around one thousand times as much time as a simulation using a cycle-based ISS system 61.

While it is also possible to make the original specification 31 using C++ so as to redundancy being not present, this method has the following problem. First, there are the differences in the sizes of objects that are generated by the object oriented language C++ and by the standard procedural language C. The size of objects for an object oriented language is usually around 30 to 50% larger. This results in the size of the objects that are compiled by the PU compiler 101 being extremely large.

With an embedded processor like a VUPU 10, how the size of the memory on the silicon can be reduced is an extremely important factor with respect to cost and power consumption. Therefore, the specification originally designed in C language has a large advantage. On the other hand, parts of the specification that are converted into VUs become hardware not objects, so that even if such parts are written in C++ language, the large size of objects mentioned earlier is not relevant. Rather, there is a larger merit in that the simulation can be performed without the bit redundancy after the eradication is done through the conversion.

Next, in design stage 115, a C-to-RTL tool performs operation level synthesis. The C++ library 63 that has been verified by the ISS simulation is converted in step 129 into a C language description for operation level synthesis performed in step 130. The resulting RTL and number of cycles are reported, so that the number of cycles is fed back to the ISS simulation (step 128 or 126) described above. Therefore, the VU instruction library 63 that has been supplemented with the number of cycles reported in stage 115 becomes replaceable software library with RTL that have been generated by the C-to-RTL operation level synthesis tool.

Stage 116 is the final design stage. In step 131, the ISS system 61 is used to perform a combined simulation for the RTL of the VU 1 and the program containing PU instructions, VU instructions and pseudo-VU instructions, thereby performing a final verification of the produced RTL of the VU 1. In this simulation, the "parent" or "master" is the RTL. In other words, to perform the simulation, initiate the parent or master RTL to linking the ISS and VU unit RTL as "children" or "slave" from the parent level. The simulation at this stage includes RTL so that the simulation speed is drop or becomes lower. However, this processing is only performed once as a final check. Furthermore, since the pseudo-VU instructions included in the program can be executed as they are by the ISS system 61, there is the merit that the same test environment can be used up to the RTL level simulation.

The RTL of the VU 1 whose operation has been subjected to a final check is logically synthesized in step 132, and in step 133, a net list is outputted and silicon chip is manufactured by the net list (converted into circuitry).

In this way, in each of the stages described above, simulations (steps 122, 126, 128, and 131) for each stage are performed using the ISS system 61. In these simulations, the description for tests introduced by pseudo-VU instructions, especially the function for comparing with expected values, in the step 121 of the first stage 111, are utilized being appended to the program simulated right up until the final stage 116 using the RTL. Consequently, with the present design method, the same test codes or descriptions can be used from the first to the last design stage, which is especially effective when verifying state of programs or functions installed in the simulator that changes little by little in each stage. This results in the significant merit of there being no danger of a fundamentally flawed circuit being taken through the design procedure as normal.

It should be noted that while the method of simulation according to the present invention has been described based on simulator 60 that is provided as a simulation program or program product, though it is possible to execute the method of simulation of the present invention using a different means, such as hard wired logic. For the simulation method of the present invention, it is preferable to provide a simulation program that can be executed on user's or other computer environment at high speed that is written in C or another high-level language such as a JAVA (registered trademark). The simulation program or program product of this invention can be provided on an appropriate medium such as a CD-ROM (Compact Disc-Read Only Memory) or provided via a computer network such as the Internet. By installing the simulation program of the present invention in suitable hardware resources such as a personal computer or a workstation, the functions of a VUPU 10 can be simulated at high speed..

The VUPU 10 includes a PU that is a general-purpose processor and at least one VU that is specialized circuitry. Compared to a conventional custom LSI (large scale integration) where an entire specification is converted into specialized circuitry, a custom LSI using the VUPU architecture can be provided by the present invention in a short time, at low cost, and with the same level performance or higher. When the simulator of the present invention is used, the development period can also be reduced. The simulator of the present invention is not restricted to VUPU and can be adapted to use for designing and developing a general-purpose processor and/or all the programs (referred to in the present specification as "application programs") executed by a processor. When the present invention is used, the accuracy of simulation will be improved and the time taken by the simulation will be reduced.

The present invention provides a simulator that is equipped with an ISS system that can simulate instructions sets using models where the instructions sets are divided into cycles of pipeline stages. This makes it possible to perform a cycle-based simulation of hardware using a high-speed simulator that is written in a high-level language such as C language. With the simulation method of the present invention, it is possible to provide a simulator or data processing system that functions as a simulator which can maintain the same level (cycle basis) of accuracy as a conventional RTL-based simulator but which can operate with between several hundred and several thousand times the simulation speed. By using the present invention, the length of the design period of a processor becomes shorter, and the design quality is improved. This has an extremely large effect on the cost performance on the products designed.

In addition, the present invention gives a high speed cycle basis simulating method for hardware of a processor, such as a VUPU, that equipped with a special-purpose processing unit with a special-purpose data path by managing the number of cycles consumed at the special-purpose processing units under the special-purpose instructions using a "library".

By introducing pseudo-VU instructions (and in particular zero-cycle pseudo-VU instructions) that are not executed by a processor, a function act as test circuits that are effective for evaluation and verification can be used or applied from the first design stage to the final RTL generation stage as pseudo-VU instructions. By converting the processing by VU instructions into a library, it becomes extremely easy to eradicate bit redundancies by converting the library to another language, such as C++ language. Also, the simulator of the present invention is a cycle-based ISS system, so that simulation that is linked to the RTL generated in the final stage can be performed, meaning that the simulator can be used right up to the final verification.

## Claims

1. A data processing system that simulates operation of a processor for an application program including instruction sets, an instruction cycle of each of the instruction sets being performed with pipeline stages in the processor,
wherein the data processing system comprises cycle-level simulating means for simulating operation of the processor controlled by the application program in cycles of the pipeline stages.

2. A data processing system according to Claim 1,
further comprising a library for converting each pipeline stage of each of the instruction sets into first information that can be managed by the cycle-level simulating means.

3. A data processing system according to Claim 2,
wherein the cycle-level simulating means performs simulation according to the first information based on second information related to processing that is common to every pipeline stage.

4. A data processing system according to Claim 1,
wherein the processor includes a general-purpose processing unit for executing general-purpose processing and a special-purpose processing unit that is dedicated to special data processing,
the data processing system further comprising:
a general-purpose instruction library for converting each pipeline stage of each general-purpose instruction set, included in the application program, that specifies processing by the general-purpose processing unit into information that can be managed by the cycle-level simulating means; and
a special-purpose instruction library for converting each special-purpose instruction set, included in the application program, that specifies processing by the special-purpose processing unit into information that can be managed by the cycle-level simulating means.

5. A data processing system according to Claim 4,
wherein the special-purpose instruction library provides the cycle-level simulating means with the information including a number of the cycles consumed by the each special-purpose instruction set.

6. A data processing system according to Claim 4 or 5,
wherein the special-purpose instruction library provides the cycle-level simulating means with the information including a state of the special-purpose processing unit based on the cycles.

7. A data processing system according to Claim 4, 5 or 6,
wherein the special-purpose instruction library is produced by
(i) converting a specification part, out of a specification specifying operation of the processor, that is executed by the special-purpose instruction set into a different language to an original language in which the specification is written and
(ii) compiling the converted specification part into the special-purpose instruction set.

8. A data processing system according to any of the preceding claims,
wherein the application program includes at least one pseudo-instruction set that is not executed by the processor, and the data processing system further comprises a pseudo-instruction library for converting each pseudo-instruction set into information that can be managed by the cycle-level simulating means.

9. A data processing system according to Claim 8,
wherein the at least one pseudo-instruction set comprises instructions that specify processing for which the cycles are not counted.

10. A data processing system according to Claim 4,
wherein the application program includes at least one pseudo-instruction set that is not executed by the processor, and the data processing system further comprises a pseudo-instruction library for converting each pseudo-instruction set into information that can be managed by the cycle-level simulating means, the at least one pseudo-instruction set comprising instructions that specify processing fo evaluating, without the cycles being counted, results of a simulation of processing by the general-purpose processing unit and/or the special-purpose processing unit.

11. A data processing system according to any one of claims 4 to 10,
wherein at least one general-purpose instruction set comprises an assembler instruction.

12. A design method for a processor for an application program including instruction sets, an instruction cycle of each of the instruction sets being performed with pipeline stages in the processor,
wherein the design method comprises a cycle-level simulating step for simulating operation of the processor controlled by the application program in cycles of the pipeline stages.

13. A design method according to Claim 12,
further comprising a step of converting, before the cycle-level simulating step, each pipeline stage of each of the instruction sets into first information that can be managed by the cycle-level simulating step.

14. A design method according to Claim 13,
wherein in the cycle-level simulating step, simulation is performed according to the first information based on second information related to processing that is common to every pipeline stage.

15. A design method according to Claim 12,
wherein the processor includes a general-purpose processing unit for executing general-purpose processing and a special-purpose processing unit that is dedicated to special data processing,
and the design method further comprises:
a first step of converting each pipeline stage of each general-purpose instruction set, included in the application program, that specifies processing by the general-purpose processing unit into information that can be managed by the cycle-level simulating step; and
a second step of converting each special-purpose instruction set, included in the application program, that specifies processing by the special-purpose processing unit into information that can be managed by the cycle-level simulating step.

16. A design method according to Claim 15,
further comprising a step of generating a special-purpose instruction library that is used by the second step of converting and includes,
(i) extracting a specification part, out of a specification specifying operation of the processor, that is executed by the special-purpose instruction set and
(ii) replacing the specification part into the special-purpose instruction set.

17. A design method according to Claim 16,
wherein the step of generating the special-purpose instruction library generates the special-purpose instruction library by compiling the specification part that is to be executed by the special-purpose instruction set after the specification part has been converted from an original language into a different language.

18. A design method according to Claim 15, 16 or 17,
wherein the second step of converting provides the cycle-level simulating step with the information including a number of the cycles consumed by the special-purpose instruction set.

19. A design method according to any one of claims 15 to 18,
wherein the second step of converting provides the cycle-level simulating step with the information including a state of the special-purpose processing unit based on the cycles.

20. A design method according to any one of claims 12 to 19,
wherein the application program includes at least one pseudo-instruction set that is not executed by the processor, and the design method further comprises a third step of converting that converts each pseudo-instruction set into information that can be managed by the cycle-level simulating step.

21. A design method according to Claim 20,
wherein the at least one pseudo-instruction set comprises instructions that specify processing for which the cycles are not counted.

22. A design method according to Claim 15, or any one of claims 16 to 21 when appended to Claim 15,
wherein the application program includes at least one pseudo-instruction set that is not executed by the processor, and the design method further comprises a pseudo-instruction library for converting each pseudo-instruction set into information that can be managed by the cycle-level simulating step, the at least one pseudo-instruction set comprising instructions that specify processing for evaluating, without the cycles being counted, results of a simulation of processing by the general-purpose processing unit and/or the special-purpose processing unit.

23. A design method according to Claim 12,
further comprising a first and second simulating step of simulating a processor that is equipped with a general-purpose processing unit for executing general-purpose processing and a special-purpose processing unit that is dedicated to special data processing,
wherein the first simulating step performs a simulation in which pseudo-instruction sets, which evaluate a simulated state and for which the cycles are not counted, are used in addition to instructions that are based on a specification specifying operation of the processor,
the second simulating step includes the cycle-level simulating step and performs a simulation after (i) converting, out of the instructions, each general-purpose instruction set that specifies processing for the general-purpose processing unit into information, which can be managed by the cycle-level simulating step that simulates each pipeline stage of the general-purpose instruction set, (ii) converting, out of the instructions, each special-purpose instruction set that specifies processing for the special-purpose processing unit into information which can be managed by the cycle-level simulating step based on a special-purpose instruction library, and (iii) converting each pseudo-instruction set into information which can be managed by the cycle-level simulating step based on a pseudo-instruction library,
the design method further comprising a step of generating the special-purpose instruction library, before the second step of simulating, for extracting a specification part, out of a specification specifying operation of the processor, that is to be executed by special-purpose instruction sets, and replacing the extracted part with the special-purpose instruction set.

24. A design method according to Claim 23,
wherein the step of generating the special-purpose instruction library generates the special-purpose instruction library by compiling the specification part that is to be executed by special-purpose instruction sets after the specification part has been converted from an original language to a different language.

25. A design method according to Claim 23 or 24,
further comprising a step of generating the pseudo-instruction library before the first simulating step.

26. A design method according to Claim 23, 24 or 25,
further comprising a step of converting the special-purpose instruction library into RTL (register transfer language) and a third simulating step,
wherein the third simulating step includes the cycle-level simulating step and performs simulation after _(i) converting each pipeline stage of each general purpose instruction set into information that can be managed by the cycle-level simulating step, (ii) converting each special-purpose instruction set, based on the special-purpose instruction library that has been converted into RTL, into information that can be managed by the cycle-level simulating step, and (iii) converting each pseudo-instruction set into information which can be managed by the cycle-level simulating step based on the pseudo-instruction library.

27. A program product that simulates operation of a processor for an application program including a plurality of instruction sets, an instruction cycle of each of the instruction sets being performed with pipeline stages in the processor,
wherein the program product comprises an instruction for executing a cycle-level simulating process that simulates operation of the processor controlled by the application program in cycles of the pipeline stages.

28. A program product according to Claim 27,
further comprising an instruction for executing a process for converting, before the cycle-level simulating process, each pipeline stage of each of the instruction sets into first information that can be managed by the cycle-level simulating process.

29. A program product according to Claim 28,
wherein in the cycle-level simulating process, simulation is performed according to the first information based on second information related to processing that is common to every pipeline stage.

30. A program product according to Claim 27,
wherein the processor includes a general-purpose processing unit for executing general-purpose processing and a special-purpose processing unit that is dedicated to special data processing,
and the program product further comprises instructions for performing:
a first converting process of converting each pipeline stage of each general-purpose instruction set, included in the application program, that specifies processing by the general-purpose processing unit into information that can be managed by the cycle simulation process; and
a second converting process of converting each special-purpose instruction set, included in the application program, that specifies processing by the special-purpose processing unit into information that can be managed by the cycle simulation process.

31. A program product according to any one of claims 27 to 30,
wherein the instruction sets include at least one pseudo-instruction set that is not executed by the processor, and the program product further comprises an instruction for performing a third converting process that converts each pseudo-instruction set into information that can be managed by the cycle-level simulating process.

32. A program product according to Claim 31,
wherein processing for which the cycles are not counted is performed according to the at least one pseudo-instruction set.

33. A program product according to Claim 30,
wherein the application program includes at least one pseudo-instruction set that is not executed by the processor, and the program product further comprises an instruction that is capable of executing a third converting process for converting each pseudo-instruction set into information that can be managed by the cycle-level simulating process, the at least one pseudo-instruction set being used to perform processing for evaluating, without the cycles being counted, results of a simulation of processing by the general-purpose processing unit and/or the special-purpose processing unit.

34. A library program product capable of executing a process that (i) converts each pipeline stage of each of instruction sets in an application program, an instruction cycle of each of the instruction sets being performed with pipeline stages, into information that can be managed by a simulation program that simulates operation of a processor controlled by the application program and (ii) supplies the information to the simulation program.

35. A library program product according to Claim 34,
wherein the processor that the simulation program simulates is equipped with a general-purpose processing unit for executing general-purpose processing and a special-purpose processing unit that is dedicated to special data processing,
the library program being capable of:
a first converting process of converting each pipeline stage of each general-purpose instruction set, in the application program, that specifies processing by the general-purpose processing unit into information that can be managed by the simulation program; and
a second converting process of converting each special-purpose instruction set, in the application program, that specifies processing by the special-purpose processing unit into information that can be managed by the simulation program.

36. A library program product according to Claim 34,
wherein the processor that the simulation program simulates is equipped with a general-purpose processing unit for executing general-purpose processing and a special-purpose processing unit that is dedicated to special data processing, and
the library program is capable of performing a converting process that converts each special-purpose instruction set, in the application program, that specifies processing by the special-purpose processing unit into information that can be managed by the simulation program.

37. A library program product according to Claim 36,
wherein the converting process provides the simulation program with information including a number of the cycles consumed by a special-purpose instruction set.

38. A library program product according to Claim 36 or 37,
wherein the converting process provides the simulation program with information including a state of the special-purpose processing unit of the cycles base.

39. A library program product of Claim 36, 37 or 38,
wherein the information produced by the converting process is provided by a module, the module compiled from a specification part, out of a specification specifying operation of the processor, that is to be executed by a special-purpose instruction set after the specification part has been converted from an original language to a different language.

40. A library program product of any one of claims 34 to 39,
wherein the application program includes at least one pseudo-instruction set that is not be executed by the processor, and the library program product is also capable of performing a third converting process that converts each pseudo-instruction set into information that can be managed by the simulation program.

41. A library program product of Claim 40,
wherein the at least one pseudo-instruction set comprises instructions that specify processing for which the cycles are not counted.

42. A program product including instructions capable of executing a process that converts each pipeline stage of each of instruction sets in an application program, an instruction cycle of each instruction set being performed with a pipeline stage, into simulation models in which each instruction set is expressed in notation divided into each of the pipeline stages.

43. A design system for a processor for an application program including instruction sets, an instruction cycle of each of the instruction sets being performed with pipeline stages.
wherein the design system comprises cycle-level simulating means for simulating operation of the processor controlled by the application program in cycles of the pipeline stages.

44. A design system according to Claim 43,
wherein the processor includes a general-purpose processing unit for executing general-purpose processing and a special-purpose processing unit that is dedicated to special data processing,
and the design system further comprises:
a means for (i) converting each pipeline stage of each general-purpose instruction set, in the application program, that specifies processing by the general-purpose processing unit into information that can be managed by the cycle-level simulating means (ii) converting, based on a special-purpose instruction library, each special-purpose instruction set, in the application program, that specifies processing by the special-purpose processing unit into information that can be managed by the cycle-level simulating means, and (iii) simulating by the cycle-level simulating means; and
means for extracting, out of a specification that stipulates operation of the processor, a specification part that is to executed by special-purpose instruction sets, replacing the extracted specification part with the special-purpose instruction sets, and generating the special-purpose instruction library.

45. A design system according to Claim 44, further comprising:
means for converting the special-purpose instruction library into RTL.

46. A design system according to Claim 43,
wherein the processor includes a general-purpose processing unit for executing general-purpose processing and a special-purpose processing unit that is dedicated to special data processing,
and the design system comprises:
first means for simulating instructions that are based on a specification specifying an operation of the processor with pseudo-instructions, which evaluate a simulated state and for which the cycles are not counted;
second means for (i) converting, out of the instructions, each general-purpose instruction set that specifies processing for the general-purpose processing unit into information, which can be managed by the cycle-level simulating means, on each pipeline stage of each of the general-purpose instruction sets, (ii) converting, out of the instructions, each special-purpose instruction set that specifies processing for the special-purpose processing unit into information which can be managed by the cycle simulation means, based on a special-purpose instruction library, (iii) converting each pseudo-instruction set into information which can be managed by the cycle-level simulating means, based on a pseudo-instruction library, and (iv) simulating by the cycle-level simulating means; and
means for extracting a specification part, out of a specification specifying an operation of the processor, that is to be executed by special-purpose instruction sets, replacing the extracted part with the special-purpose instruction set, and generating the special-purpose instruction library.
